# EUROPEAN PATENT SPECIFICATION

(11) **EP 1 336 993 B1**
(45) Date of publication and mention of the grant of the patent: **27.12.2006**
(21) Application number: 02425079.7
(22) Date of filing: 18.02.2002
(51) Int. Cl.: H01L 23/495

(54) **Assembly structure for electronic power integrated circuit formed on a semiconductor die and corresponding manufacturing process**
Zusammenbaustruktur für einen Integrierten Leistungsschaltkreis auf einem Halbleiterchip und Verfahren zur Herstellung
Structure d'assemblage pour circuit intégré de puissance formée sur une puce semiconductrice et procédé de fabrication

(43) Date of publication of application: 20.08.2003
(73) Proprietor: STMicroelectronics S.r.l., 20041 Agrate Brianza (Milano) (IT)
(72) Inventor: Casati, Paolo, 20099 Sesto S. Giovanni (Milano) (IT); Maierna, Amedeo, 27010 Albuzzano (Pavia) (IT); Murari, Bruno, 20052 Monza (IT)
(74) Representative: Botti, Mario

(56) References cited:
- US-A- 5 235 207
- US-A- 5 696 032
- US-B1- 6 201 186

## Description

### Field of Application

The present invention relates to an assembly structure for electronic integrated power circuit formed on a semiconductor die and corresponding manufacturing process.

Specifically, the invention relates to an assembly structure for an electronic integrated power circuit formed on a semiconductor die comprising a plurality of contact pads associated with said integrated circuit and connected electrically to respective rheophores of said structure.

The invention further relates to a process for manufacturing an assembly structure for an electronic integrated power circuit formed on a semiconductor die having a plurality of rheophores, the process comprising the following step:
- forming a plurality of contact pads in a peripheral area of an active face of said die.

The invention relates, particularly but not exclusively, to an assembly structure for an integrated power circuit for use in SMT (Surface-Mount Technology) applications, this specification covering this field of application for convenience of illustration only.

### Prior Art

As is well known, semiconductor electronic devices, e.g. power devices, comprise a small plate of a semiconductor material, known as the "die" or "chip", which has a surface area of a few square millimeters on which electronic circuit is monolithically integrated. This die has a plurality of terminals, typically as contact pads (typically formed from metal), which are provided on its surface and electrically connected, during the manufacturing process, to an outer frame, the latter being also made of metal and a part of the electronic device.

The electrical connection of the die of semiconductor material to the frame can be achieved by different technologies, including one that provides wire connections and is commonly referred to as the "wire bonding" technique. More particularly, each connecting wire is welded with one end on a contact pad that has been formed on the die of semiconductor material, and with the other end, on a corresponding rheophore formed on the frame to which the die is to be connected.

Electronic power devices are widely used in all branches of electronics. Particularly in the automobile industry, automobile vehicles are equipped with electronic control units for controlling the operation of vehicle components, which control units comprise electronic power devices.

Such control units are becoming more and more compact in size and provide an increasing number of functions, which results in increased power density and consequently increased heat generated from the integrated circuits.

More particularly, it has been found that in such cases, wire bonding is inadequate to handle high current densities, referred to as high powers hereinafter. The size of the leads employed is on the order of 35 µm, and the lead contacts are not sufficiently reliable to handle currents in excess of a few Ampères.

There exists, therefore, a demand for semiconductor electronic devices, especially power devices, which can be operated under unfriendly conditions, e.g. in environments where wide temperature fluctuations up to 180°C are to be expected.

Another demand that comes from the automotive industry, as well as from electronic applications (printers, interfaces, mobile phone apparatus), is for electronic devices that are substantially unaffected by electromagnetic radiation while doing without cumbersome shielding arrangements.

The underlying technical problem of this invention is to provide an assembly structure for an electronic integrated power circuit designed for high-power applications, which has appropriate structural and functional features assure a good immunity to electromagnetic radiation and adapted to better dissipate heat, thereby overcoming the drawbacks of prior art devices.

The technical problem that underlies the invention is also to provide a process for manufacturing assembly structures for integrated power circuits, whereby the problems of connecting the chip terminals, with the chip mounted bare on a board, to the path of the external circuit are solved, and the prior art constraints from the use of wire-bonding equipment and low current capacity wires avoided.

### Summary of the Invention

The solvent idea of this invention is one of fitting an integrated power circuit within a metal mount structure (frame) incorporating a shield element that operates as a shield from electromagnetic radiation and at the same time as a heat sink.

Thus, the invention is an assembly structure for an integrated power circuit, wherein a shield element and all the contact rheophores are formed on one and the same metal sheet, and the semiconductor crystal is attached to the metal structure (frame) before the rheophores are welded to the die and then trimmed and formed to a typical gullwing shape.

The invention further relates to a process for manufacturing such an assembly structure for an integrated power circuit.

Advantageously in the method of the invention, the rheophores are connected to the die by a TAB (Tape Automated Bonding) process. Based on this solvent idea, the technical problem is solved by an assembly structure for an integrated power circuit as previously indicated and as defined in the characterizing portion of Claim 1.

The problem is further solved by a process as previously indicated and as defined in the characterizing portion of Claim 7.

The features and advantages of the structure and the process according to the invention will become apparent from the following description of embodiments thereof, given by way of non-limitative examples with reference to the accompanying drawings.

### Brief Description of the Drawings

In the drawings:

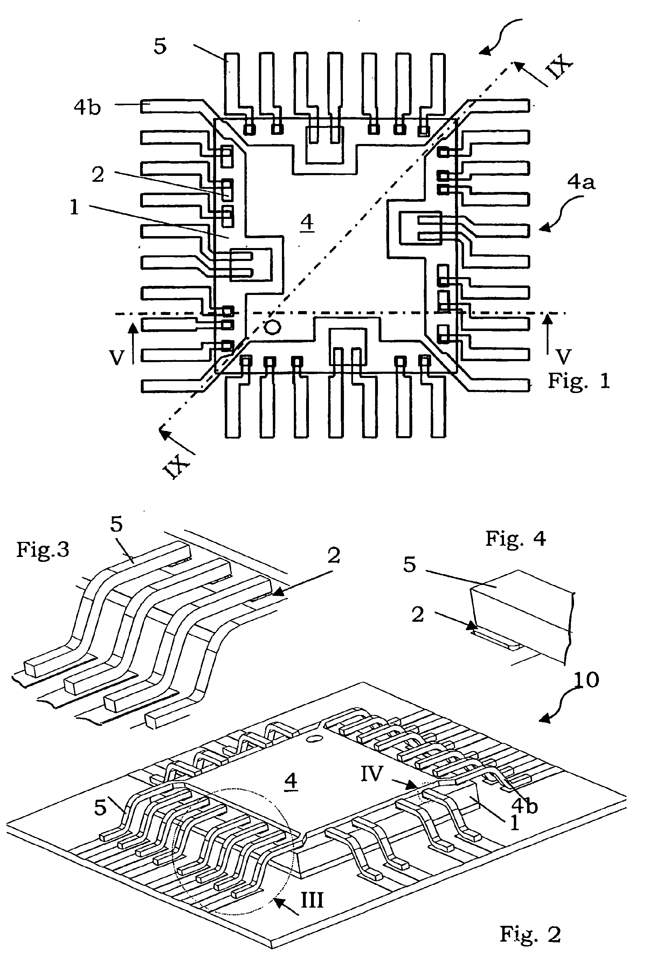

Figure 1 is a top plan view of an assembly structure according to the invention;
Figure 2 is an isometric view of the assembly structure shown in Figure 1;
Figure 3 is a first, enlarged detail view of the assembly structure shown in Figure 2;
Figure 4 is a second, enlarged detail view of the assembly structure shown in Figure 2;

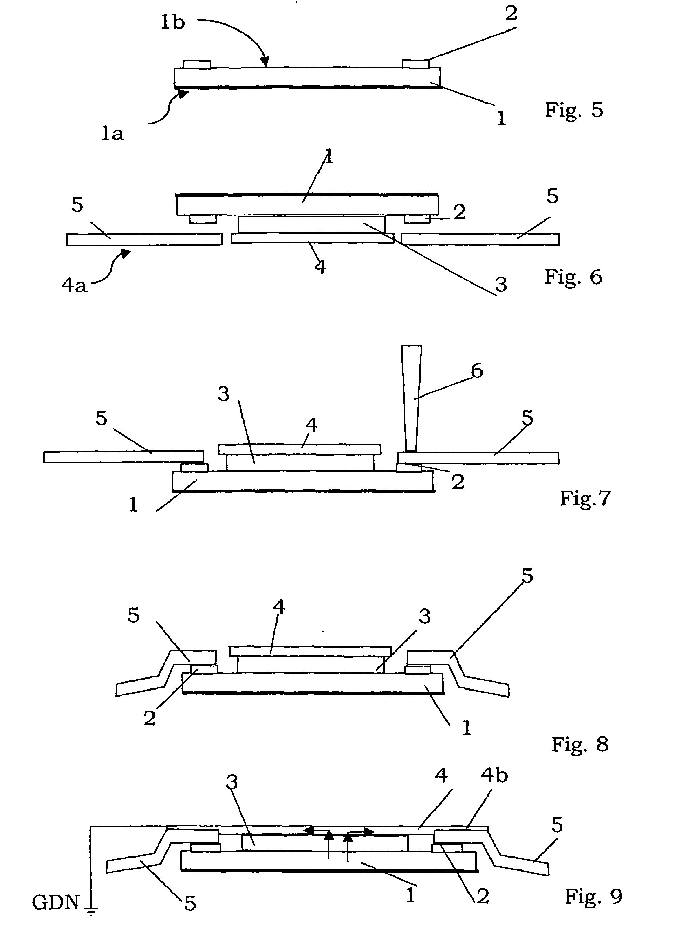

Figures 5 to 8 are sectional views, taken along line V-V of the assembly structure shown in Figure 1, at different steps of this assembly structure manufacture;
Figure 9 is a sectional view, taken along line IX-IX, of the assembly structure shown in Figure 1;
Figure 10 is an electron microscope (SEM) showing the detail of Figure 4;
Figure 11 is a photograph of a rheophore of the structure in Figure 1;
Figure 12 is an electron microscope (SEM) showing the detail of Figure 4 in side view.

### Detailed Description

With reference to the drawings, there is shown an assembly structure 10 for an electronic integrated power circuit fabricated on a semiconductor plate 1, the semiconductor plate (die) 1 being coupled thermally to a shield element or die blocking pad 4. The semiconductor plate 1 is coupled electrically to a plurality of pins (rheophores) 5 through a respective plurality of weld pads (bumped pads) 2.

In particular, the die 1 is obtained from silicon wafers having a bottom provided conventionally with a metal layer 1a. The metal layer 1a may be, for example, a chromium/nickel/gold alloy. This metal layer 1a may be a thick metallization layer, up to 100-micron thick, of copper or another suitable metal to establish a secure weld to the rheophores at the same time as good conduction of heat

The die blocking pad 4 is of metal sheet and substantially square in shape, with suitable extensions 4b formed at its corners.

Advantageously in this invention, the extensions 4b of the die blocking pad 4 can be connected to a ground lead outside the structure 10. In this way, the die blocking pad 4 effectively provides good electromagnetic protection for the integrated components in the die 1.

The die blocking pad 4 is also effective to reduce thermal resistance and dissipate heat from small powers generated for a short time (100 ms to 1 second).

This heat-dissipating action is made possible by the die 1 being attached to the die blocking pad 4 through a layer 3 of an adhesive material. This adhesive layer 3 may be either a thermoplastic material or a thermosetting material which is a good heat conductor effective to dissipate heat from the die 1. This material may be a polyimide adhesive layer.

Thus, the die blocking pad 4 doubles as an electromagnetic shield and a heat sink.

With powers that are generated for a longer time, heat is dissipated from the assembly structure 10 conventionally: the heat is transferred through the die 1 into the underlying substrate, i.e. heat is dissipated through the die bottom and the metal layer 1a.

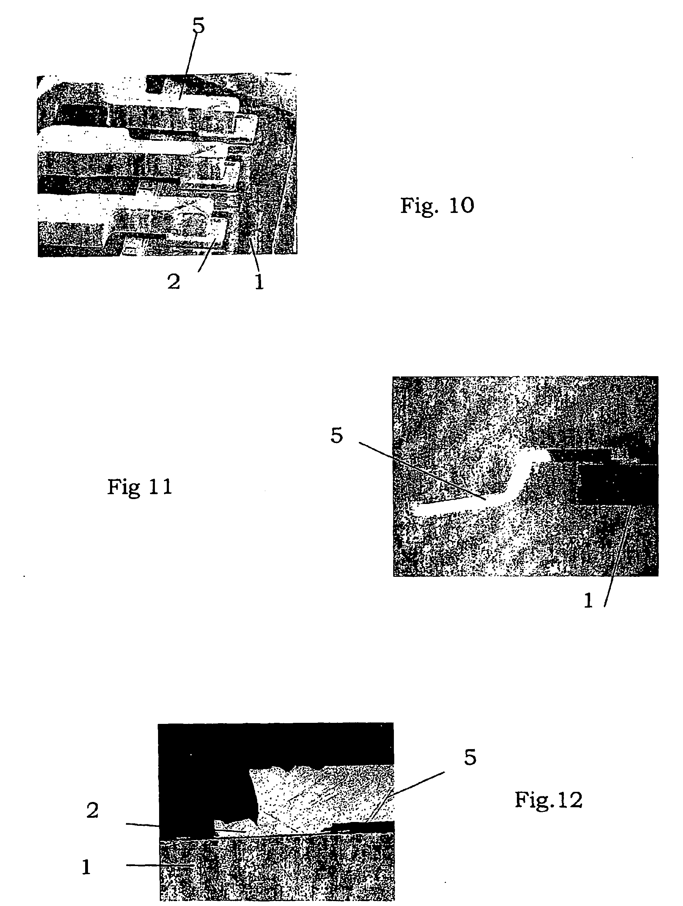

A final molding operation gives the rheophore 5 its typical gullwing shape, as shown in Figure 11.

The process of this invention for manufacturing the assembly structure 10 for an electronic integrated power circuit, will now be described.

A plurality of contact pads (bumps) 2 are formed on the peripheral end of the die 1. These pads are formed, in particular, on an active face 1b of the die 1. The active face 1b is here that portion of the die 1 where the electronic circuits are integrated. These contact pads 2 are obtained, for instance, by electrolytically depositing pure gold onto a thin titanium/tungsten (TiW) barrier. Alternatively, these contact pads 2 may be obtained by deposition of a nickel/gold alloy in a non-electrolytic (electroless) process.

Advantageously, these contact pads 2 are formed to a uniform thickness of about 20 to 25 microns, and are planar to the surface of the die 1.

The die blocking pad 4 is formed within a conductive frame (leadframe) 4a made of thin sheet copper or another suitable metal, and is suitably patterned to meet circuit requirements. In particular, the frame 4a is cut out (as by shearing or etching) to include a plurality of narrow strips representing electric connectors or rheophores (leads) 5 with a substantially sunburst pattern radiating from the centrally located die blocking pad 4.

Advantageously, a plurality of assembly structures 10 can be formed from a same frame 4a.

In a preferred embodiment, the rheophores 5 are copper, 130 to 150-micron wide and about 100-micron thick, and adapted to handle the currents generated by the integrated power circuits that are fabricated on the die 1.

A layer 3 of an adhesive material is deposited, or laminated, onto the die blocking pad 4. This adhesive layer 3 may be a polyimide adhesive layer, for example. However, there is no reason why this adhesive layer could be also dispensed onto the die blocking pad or shield element.

This adhesive layer 3 may be provided on the die 1 instead. Advantageously, the thickness of the adhesive layer 3 is within the range of 25 to 100 microns.

According to the invention, the active face 1b of the die 1, carrying the contact pads 2, is arranged to face the rheophores 5 in alignment thereto. The die 1 is then pressed onto the adhesive layer 3 and brought to setting process temperature.

Advantageously, the die 1 is pressed onto the die blocking pad 4 through the thermofixing adhesive layer 3, with the setting temperature of about 260°C, for about one second under a pressure of 14 Newtons, with a 4x5 mm die, to bond the die 1 and die blocking pad 4 adhesively together.

Advantageously, this mutual bond of the die 1 and the die blocking pad 4, as provided in the process for manufacturing the assembly structure of this invention, allows the die of semiconductor material to be positioned with good accuracy. The bond of the die of semiconductor material to the die blocking pad 4 has shown on testing a good capacity to resist delamination, or in other words, that a considerably large force must be applied in order to separate the die 1 from the die blocking pad 4.

With the resulting structure 10 turned over 180°, the electric connection of the contact pads 2 to the rheophores 5 is then made.

Advantageously, this connecting operation is realised by a thermo-sonic welding process. In this way, the rheophores 5 are welded on the contact pads 2. In the preferred embodiment, the copper rheophores 5 are 130 to 150 microns wide and about 100 microns thick.

Tests performed by the Applicant have demonstrated the separation resistance of the rheophores 5 and the die 1 of semiconductor material, i.e. that a considerably large force must be applied to break the bond between the rheophores 5 and the die 1. In particular, a force of up to 400 grams may have to be applied where a 130-micron rheophore 5 is involved. Excellent results also realised measurements made of the voids at the interface between the rheophores 5 and the contact pads 2.

The electrical connecting operation could also be a reflow or eutectic welding process using, for instance, a gold/tin alloy in eutectic diagram proportions, such as 80/20 Sn/Au.

At this stage of the process, the structures formed within the frame 4a are trimmed and formed.

In particular according to the invention, the formed structures 10 are placed on a mold having as many hollows as are the structures in the frame 4a. A punch is lowered onto the rheophores 5 to hold them mechanically and cut them to size; it also starts them into the typical gullwing shape of surface-mounted components.

Advantageously, the step of trimming and forming the rheophores 5 is a one-shot process.

The resulting structures are conventionally placed into a final package.

As said before, in the process of this invention the die 1 is adhered with its active face 1a to the die blocking pad or shielding layer 4, and the contact pads 2 are then welded to the rheophores 5, this procedure making for a less critical operation of aligning the die 1 to the rheophores 5.

Advantageously, the structure 10 of this invention employs rheophores 5 with a thickness of 100 µm, so that they can handle the currents used in automotive applications.

Advantageously, the manufacturing process of this invention uses TAB (Tape Automatic Bonding) welding processes, a TAB process being a process in which the die 1 is connected electrically to an external circuit by connecting the contact pads 2 to the rheophores 5 directly.

In particular, the frame 4a where the rheophores 5 are formed includes a polyimide dielectric layer or an insulative layer of another suitable material, onto which a layer of a metal, e.g. copper, is laminated. Polyimide layers are known for being layers of a thermoplastic material that retains its insulative property even at a high temperature. Accordingly, this technique is used to advantage in automobile applications by reason of the excellent performance in unusually high temperature applications that it provides.

The frame 4a is then photocutted into and wrought conventionally to produce the rheophores and die blocking pads or shield elements 4 as described hereinabove.

The formed rheophores 5 are bonded to the die 1 as previously described.

In another embodiment, the die blocking pad 4 may be split topologically into several copper zones isolated from one another. By providing such zones, the weld pads can be contacted also on the opposite side of the die 1. The die blocking pad 4 can, therefore, be used to make the electric contacts, additionally to its electromagnetic shielding function.

In particular, the die blocking pad 4 is suitably wrought in such applications to form suitable tracks on its inside for electrical connection purposes.

Summarizing, the inventive process for manufacturing the structure 10 comprises the following steps:
- preparing contact pads, i.e. contacts, on the semiconductor plate 1, in a peripheral area of an active face of said plate 1, by a metallizing process using gold or another metal that responds well to bonding;
- affixing the semiconductor plate 1 to a mounting frame/circuit, e.g. by an adhesive process using insulative matrix glues or thermoplastic tapes;
- electro-mechanically connecting the ends of the rheophores 5 by a point-to-point thermo-sonic or eutectic bonding (e.g. 80/20 Sn/Au) process;
- trimming and forming the outer zone of the rheophores by a cold process using a set of suitably prepared molds and punches.

In conclusion, the assembly structure 10 for an integrated power circuit, including a shield element according to the invention, provides the following advantages:
- a capability to handle large currents of up to 8-10 Ampères, from the use of much thicker rheophores than with conventional techniques;
- a high capability for heat dissipation and a low thermal resistance between the semiconductor junction and the substrate, Rth (j-sub), especially when operated at the widely varying temperatures, in the -40° to +125°C range, that automobile applications involve; in particular, this allows the structure 10 of this invention to be mounted on electronic boards or hybrid circuits of automobile vehicles by a fully automated process;
- suitability to STM (Surface Mount Technology) mounting thanks to the gullwing shape of the rheophores, which makes the structure of this invention a suitable one for use in a fully automated pick-and-place system;
- the process and structures are entirely lead-free;
- a heat-sink element that is integrated to the structure by adhering the die of semiconductor material onto a die blocking pad or shield element 4 with a thermoplastic layer therebetween; the integrated circuit in the die can also dissipate heat through the die blocking pad 4, especially for the short-term pulse (periods of 10 to 1000 milliseconds), so that a reduction in the junction-to-substrate thermal resistance, Rth (j-sub), is later achieved; this metal die blocking pad 4 will also protect the integrated circuit against electromagnetic waves, when connected to a suitable static electric potential.

In conclusion, the assembly structure 10 of this invention has reduced ultimate space requirements, comparable to those of class CSP (Chip Scale Package) components, and no wire connections (wire bonding), while the input/output rheophores of the integrated power circuit can sustain large currents.

## Claims

1. An assembly structure (10) for an electronic integrated power circuit, which circuit is formed on a semiconductor die (1) comprising a plurality of contact pads (2) associated with said integrated circuit and coupled electrically to respective pins or rheophores (5) of said structure, **characterized in that** said assembly structure comprises a shield element (4) or die blocking pad coupled thermally to said die (1) by a layer (3) of an adhesive material thus providing electromagnetic shield and heat sink to said die.

2. An assembly structure (10) according to Claim 1, **characterized in that** said adhesive layer (3) is a layer of either a thermoplastic material or a thermosetting material.

3. An assembly structure (10) according to Claim 1, **characterized in that** said shield element (4) and said rheophores are formed in one and the same frame (4a).

4. An assembly structure (10) according to Claim 2, **characterized in that** said frame (4a) comprises a layer of a polyimide or polymer material and a layer of a metal material.

5. An assembly structure (10) according to Claim 2, **characterized in that** the thickness of said frame (4a) is 100 µm.

6. An assembly structure (10) according to Claim 1, **characterized in that** said shield element (4) includes a plurality of electrical paths for electrical connection to the die (1)

7. A process for manufacturing an assembly structure (10) for an electronic integrated power circuit formed on a semiconductor die (1) comprising a plurality of pins or rheophores (5), the process comprising the following step:
- providing a plurality of contact pads (2) in a peripheral area of an active face (1a) of said die; **characterized in that** it comprises the following steps:
- forming a layer (3) of an adhesive material on said active face (1a) of the die (1);
- adhering said die (1) on a shield element (4) or die blocking pad by means of said adhesive layer (3) thus providing electromagnetic shield and heat sink to said die;
- aligning said contact pads (2) to said rheophores (5), and connecting said contact pads (2) mechanically and electrically to said rheophores (5);
- holding and cutting said rheophores (5), and concurrently forming said rheophores into a gullwing shape.

8. A process for manufacturing an assembly structure (10) according to Claim 7, **characterized in that** said adhesive layer (3) is a layer of a thermoplastic material.

9. A process for manufacturing an assembly structure (10) according to Claim 7, **characterized in that** said electrical connection between said contact pads (2) and said rheophores (5) is achieved by a thermo-sonic welding technique.

10. A process for manufacturing an assembly structure (10) according to Claim 7, **characterized in that** said electrical connection between said contact pads (2) and said rheophores (5) is achieved by a reflow welding technique.

11. A process for manufacturing an assembly structure (10) according to Claim 7, **characterized in that** said shield element (4) and said rheophores (5) are formed in one and the same frame (4a), with the latter being photocutted into and wrought to have said shield element (4) at the center of said frame (4a) and said rheophores (5) radiating across a peripheral area of said frame (4a).

12. A process for manufacturing an assembly structure (10) according to Claim 7, **characterized in that** said electrical connection between the contact pads (2) and the rheophores (5) is achieved by a TAB (Tape Automated Bonding) technique performed on a very thick metal material.

## Patentansprüche

1. Montagekonstruktion (10) für eine elektronische integrierte Leistungsschal-tung, wobei die Schaltung auf einem Halbleiterchip (1) mit einer Mehrzahl von Kontaktflächen (2) gebildet ist, die der integrierten Schaltung zugeordnet sind und mit jeweiligen Stiften oder Anschlussdrähten (5) der Konstruktion zugeordnet sind,
**dadurch gekennzeichnet, dass** die Montagekonstruktion ein Abschirmelement (4) oder ein Chipblockierelement aufweist, das durch eine Schicht (3) aus einem Haftmaterial mit dem Chip (1) wärmemäßig gekoppelt ist, so dass der Chip mit einer elektromagnetischen Abschirmung und einem Kühlkörper versehen ist.

2. Montagekonstruktion (10) nach Anspruch 1,
**dadurch gekennzeichnet, dass** die Haftschicht (3) eine Schicht entweder aus einem thermoplastischen Material oder aus einem unter Wärme aushärtenden Material ist.

3. Montagekonstruktion (10) nach Anspruch 1,
**dadurch gekennzeichnet, dass** das Abschirmelement (4) und die Anschlussdrähte in ein und demselben Rahmen (4a) ausgebildet sind.

4. Montagekonstruktion (10) nach Anspruch 2,
**dadurch gekennzeichnet, dass** der Rahmen (4a) eine Schicht aus einem Polyimid- oder Polymermaterial und eine Schicht aus einem Metallmaterial aufweist.

5. Montagekonstruktion (10) nach Anspruch 2,
**dadurch gekennzeichnet, dass** die Dicke des Rahmens (4a) 100 µm beträgt.

6. Montagekonstruktion (10) nach Anspruch 1,
**dadurch gekennzeichnet, dass** das Abschirmelement (4) eine Mehrzahl elektrischer Wege zur elektrischen Verbindung mit dem Chip (1) aufweist.

7. Verfahren zum Herstellen einer Montagekonstruktion (10) für eine-elektronische integrierte Leistungsschal-tung, die auf einem Halbleiterchip (1) gebildet ist, der eine Mehrzahl von Stiften-oder Anschlussdrähten (5) aufweist,
wobei das Verfahren folgenden Schritt aufweist:
- Bereitstellen einer Mehrzahl von Kontaktflächen (2) in einem Randbereich einer aktiven Fläche (1 a) des Chips;
**dadurch gekennzeichnet, dass** das Verfahren folgende weiteren Schritte aufweist:
- Bilden einer Schicht (3) aus einem Haftmaterial auf der aktiven Fläche (1a) des Chips (1);
- haftendes Anbringen des Chips (1) auf einem Abschirmelement (4) oder Chipblockierelement mittels der Haftschicht (3), um damit den Chip mit einer elektromagnetischen Abschirmung und einem Kühlkörper zu versehen;
- Ausrichten der Kontaktflächen (2) mit den Anschlussdrähten (5), und Verbinden der Kontaktflächen (2) mechanisch und elektrisch mit den Anschlussdrähten (5);
- Halten und Schneiden der Anschlussdrähten (5) sowie gleichzeitiges Ausbilden der Anschlussdrähte in eine Knickflügel-Konfiguration.

8. Verfahren zum Herstellen einer Montagekonstruktion (10) nach Anspruch 7,
**dadurch gekennzeichnet, dass** die Haftschicht (3) eine Schicht aus einem thermoplastischen Material ist.

9. Verfahren zum Herstellen einer Montagekonstruktion (10) nach Anspruch 7,
**dadurch gekennzeichnet, dass** die elektrische Verbindung zwischen den Kontaktflächen (2) und den Anschlussdrähten (5) durch eine Thermo-Schallschweißtechnik gebildet wird.

10. Verfahren zum Herstellen einer Montagekonstruktion (10) nach Anspruch 7,
**dadurch gekennzeichnet, dass** die elektrische Verbindung zwischen den Kontaktflächen (2) und den Anschlussdrähten (5) durch eine Schweißtechnik mit Wiederverflüssigung gebildet wird.

11. Verfahren zum Herstellen einer Montagekonstruktion (10) nach Anspruch 7,
**dadurch gekennzeichnet, dass** das Abschirmelement (4) und die Anschlussdrähte (5) in ein und demselben Rahmen (4a) gebildet werden, wobei letzterer durch Foto-Schneiden und Formbearbeitung derart gebildet wird, dass er das Abschirmelement (4) im Zentrum des Rahmens (4a) aufweist und die Anschlussdrähte (5) sich strahlenförmig über einen Umfangsbereich des Rahmens (4a) erstrecken.

12. Verfahren zum Herstellen einer Montagekonstruktion (10) nach Anspruch 7,
**dadurch gekennzeichnet, dass** die elektrische Verbindung zwischen den Kontaktflächen (2) und den Anschlussdrähten (5) durch eine TAB-Technick (Tape Automated Bonding bzw. automatisches Folienbondverfahren) erzielt wird, die an einem sehr dicken Metallmaterial durchgeführt wird.

## Revendications

1. Structure d'-assemblage (10) pour un circuit intégré de puissance électronique, ledit circuit étant formé sur une matrice semi-conductrice (1) comportant une pluralité de plots de contact (2) associés audit circuit intégré et couplés électriquement à des broches ou des rhéophores respectifs (5) de ladite structure, **caractérisée en ce que** ladite structure d'assemblage comprend un élément de blindage (4) ou un tampon de blocage de matrice couplé thermiquement à ladite matrice (1) par une couche (3) d'une matière adhésive, formant ainsi un blindage électromagnétique et un dissipateur thermique sur ladite matrice.

2. Structure d'assemblage (10) selon la revendication 1, **caractérisée en ce que** ladite couche d'adhésif (3) est une couche soit d'une matière thermoplastique, soit d'une matière thermodurcissable.

3. Structure d'assemblage (10) selon la revendication 1, **caractérisée en ce que** ledit élément de blindage (4) et lesdits rhéophores sont formés dans un seul et même cadre (4a).

4. Structure d'assemblage (10) selon la revendication 2, **caractérisée en ce que** ledit cadre (4a) comprend une couche de matière polyimide ou polymère et une couche de matière métallique.

5. Structure d'assemblage (10) selon la revendication 2, **caractérisée en ce que** l'épaisseur dudit cadre (4a) est de 100 µm.

6. Structure d'assemblage (10) selon la revendication 1, **caractérisée en ce que** ledit élément de blindage (4) comprend une pluralité de chemins électriques pour une connexion électrique à la matrice.

7. Procédé de fabrication d'une structure d'assemblage (10) pour un circuit intégré de puissance électronique formé sur une matrice semi-conductrice (1) comportant une pluralité de broches ou de rhéophores (5), le procédé comprenant les étapes suivantes :
- disposer une pluralité de plots de contact (2) dans une région périphérique d'une face active (1a) de ladite matrice ;
- former une couche (3) d'une matière adhésive sur ladite face active (1a) de la matrice (1) ;
- coller ladite matrice (1) sur un élément de blindage (4) ou sur un tampon de blocage de matrice au moyen de ladite couche d'adhésif (3), créant ainsi un écran électromagnétique et un dissipateur thermique sur ladite matrice ;
- aligner lesdits plots de contact (2) avec lesdits rhéophores (5), et connecter lesdits plots de contact (2) mécaniquement et électriquement auxdits rhéophores (5) ; et
- tenir et couper lesdits rhéophores (5), et simultanément donner auxdits rhéophores une forme d'aile en M.

8. Procédé de fabrication d'une structure d'assemblage (10) selon la revendication 7, **caractérisé en ce que** ladite couche d'adhésif (3) est une couche d'une matière thermoplastique.

9. Procédé de fabrication d'une structure d'assemblage (10) selon la revendication 7, **caractérisé en ce que** ladite connexion électrique entre lesdits plots de contact (2) et lesdits rhéophores (5) est réalisée par une technique de soudage thermosonique.

10. Procédé de fabrication d'une structure d'assemblage (10) selon la revendication 7, **caractérisé en ce que** ladite connexion électrique entre lesdits plots de contact (2) et lesdits rhéophores (5) est réalisée par une technique de soudage par refusion.

11. Procédé de fabrication d'une structure d'assemblage (10) selon la revendication 7, **caractérisé en ce que** ledit élément de blindage (4) et lesdits rhéophores (5) sont formés dans un seul et même cadre (4a), ce dernier étant photo-découpé et travaillé de telle sorte que ledit élément de blindage (4) soit situé au centre dudit cadre (4a) et que lesdits rhéophores (5) rayonnent à travers une région périphérique dudit cadre (4a).

12. Procédé de fabrication d'une structure d'assemblage (10) selon la revendication 7, **caractérisé en ce que** ladite connexion électrique entre les plots de contact (2) et les rhéophores (5) est réalisée par une technique de TAB (Liaison Automatique par Bande) appliquée sur un matériau métallique très épais.
